Europäisches Patentamt

(19) European Patent Office    (11) Publication number: **0 215 502**
Office européen des brevets    **B1**

(12)    # EUROPEAN PATENT SPECIFICATION

(45) Date of publication of the patent specification:    (51) Int. Cl.⁴: **H01L 21/58**
**06.12.89**

(21) Application number: **86201393.5**

(22) Date of filing: **07.08.86**

(54) Method of forming a semiconductor component with attached component bonding adhesive.

(30) Priority: **08.08.85 US 763506**

(43) Date of publication of application:
**25.03.87 Bulletin 87/13**

(45) Publication of the grant of the patent:
**06.12.89 Bulletin 89/49**

(84) Designated Contracting States:
**DE FR GB IT NL**

(56) References cited:
**EP-A- 0 135 416**
**EP-A- 0 150 882**

**PATENT ABSTRACTS OF JAPAN, vol. 9,**
**no. 39 (E-297)[1762], 19th February 1985; & JP - A**
**- 59 181 628 (TOSHIBA) 16-10-1984**

(73) Proprietor: **National Starch and Chemical Corporation,**
**10 Finderne Avenue Box 6500, Bridgewater New**
**Jersey 08807(US)**

(72) Inventor: **Lang, Mark S., 6468 Scotts Valley Drive, Scotts**
**Valley California 95066(US)**

(74) Representative: **Smulders, Theodorus A.H.J., Ir. et al,**
**Vereenigde Octrooibureaux Nieuwe Parklaan 107,**
**NL-2587 BP 's-Gravenhage(NL)**

## Description

### Field of the Invention

The present invention relates to a method of forming an adherent layer of component bonding adhesive on a semiconductor component to allow for subsequent bonding of the component to a support.

### Related Developments

In U. S. Serial No. 697,424, filed February 1, 1985, entitled "CARRIER FILM WITH CONDUCTIVE ADHESIVE FOR DICING OF SEMICONDUCTOR WAFERS" a dicing film product is described which comprises a die-bonding adhesive detachably bonded to a support film. The die bonding adhesive is adapted to support a semiconductor wafer during the dicing of the wafer into individual die or "chips". Such a dicing procedure involves the dicing of the wafer on the die bonding adhesive layer prior to formation of the individual chips and their subsequent testing to ensure that they perform acceptably. In cases where defective die are produced, there is resulting waste of the adhesive which is adherent to such a product.

An alternative product is described in EP-A 0 150 882, entitled "CONDUCTIVE DIE ATTACH TAPE". In this product, the adhesive is suitably dimensioned to conform to the area of an individual die. The product is used by affixing individual die to the adhesive and lifting off an adherent die/adhesive composite. This product can be used with previously tested die to ensure that the die which is brought into contact with the adhesive has passed the necessary quality control tests. In this way, the utilization of the adhesive would only be made with die that have passed the appropriate quality control tests.

### SUMMARY OF THE PRESENT INVENTION

It has now been found possible to bond semiconductor components, e g., semiconductor die, to an adherent layer of component bonding adhesive that is detachably supported on a support film wherein the area of the pattern of component bonding adhesive is larger than the area of the component to which it is to be affixed. The process involves bonding the desired semiconductor component to the component bonding adhesive and thereafter removing the semiconductor component with adherent layer of bonding adhesive after the adhesive has been allowed sufficient time to bond to the component. The area of the adherent layer of the component bonding adhesive attached to the component after removal from the support film needs to be of a size to allow for later bonding of the semiconductor component to the support. It has been found that as the component is lifted from the adhesive after the component has been bonded to the component bonding adhesive, that portion of the adhesive pattern in bonding contact with the component readily tears away from the remaining adhesive and is adherent to the component as it is lifted from the support film/remaining adhesive composite.

As used herein the term "semiconductor component" is to be construed in its broadest sense as including any semiconductor component or device which is adapted to be bonded to a dielectric support by use of an electrically and/or thermally conductive adhesive. It is not intended to cover such non-device items as lid seals or module covers which utilize adhesive for sealing in a gasket-like or ringline outline. Included in this category are semiconductor die or "chips" which will be used later for illustrative purposes. The term "component bonding adhesive" is also meant in its broadest sense to relate to those curable bonding adhesives which are used to bond semiconductor components to dielectric supports.

### DESCRIPTION OF THE DRAWINGS

The present invention is further understood by reference to the drawings which form a portion of the present specification wherein:

Fig. 1 shows a conventional pick-and-place apparatus with adherent semiconductor die as it is approaching a component bonding adhesive detachably mounted on a support film;

Fig. 2 shows the pick-and-place apparatus after it has brought the semiconductor die into actual contact with the adhesive: and

Fig. 3 shows the removal of the die with adherent adhesive layer by the pick-and-place apparatus.

### DETAILED DESCRIPTION OF THE PRESENT INVENTION

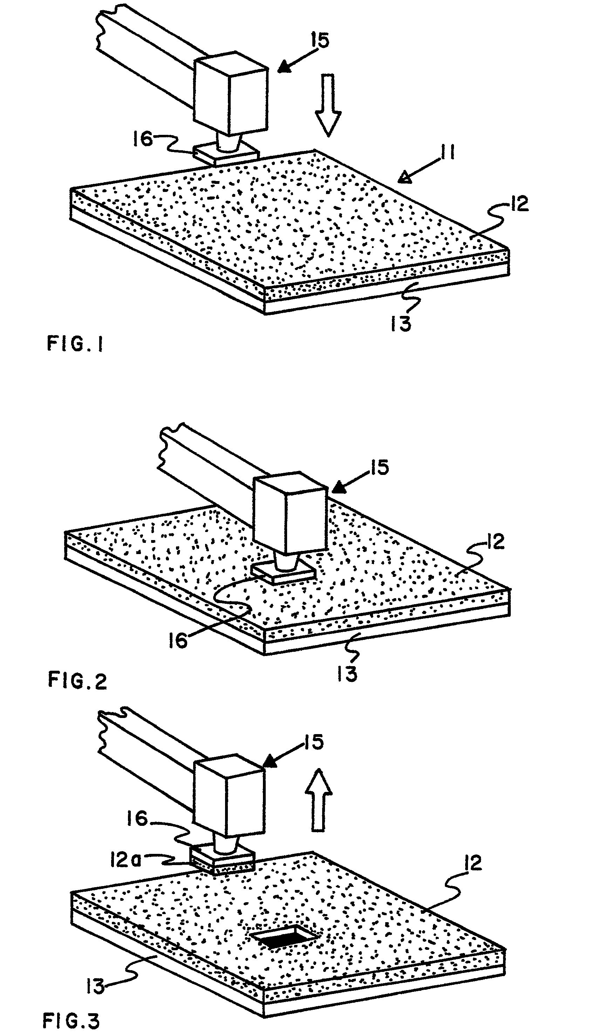

Fig. 1 illustrates a tape product 11 comprising component bonding adhesive 12 detachably mounted on a support film 13. This general type of product is shown in copending U. S. Serial Nos. 697,424 and EP-A 0 150 882 described above, each of which is incorporated herein by reference. In a preferred embodiment, the upper surface of the support film 13 carries a suitable release layer (e.g., a silicone release layer) to facilitate later release of portions of the adhesive 12 from the film 13. If desired, however, a non-release layer coated film can be used if the support film 13 has inherent release characteristics for the adhesive or if a heat treatment (such as described in EP-A 0 146 197, which is incorporated herein by reference) is utilized. The only difference between the type of product used in the present invention and the aforementioned products is in the dimension of the component bonding adhesive. In the present case, adhesive 12 covers an area on the support film 12 which is substantially greater than the area of any individual component to which it is to be bonded. In other words, the adhesive 1 can be more of a full coverage adhesive in accordance with the present invention than is specifically shown in either of the two copending applications.

The type of component bonding adhesive 12 that can be used is any type of curable adhesive which can be used in the bonding of semiconductor components to dielectric supports. Various requirements for such adhesives are known in the art and are described, for example, in U. S. Serial No. 697,424. One preferred adhesive is the polyimide-modified epoxy adhesive composition which is described in EP-A 0 171 157, which is incorporated herein by reference. This adhesive comprises an epoxy resin, a soluble polyimide resin and a reaction mono-epoxy diluent to dissolve the soluble polyimide resin into the epoxy resin. This type of adhesive would be preferred for relatively low temperature die bonding operations. Another adhesive 12 which has utility for relatively higher die bonding operations is described in EP-A 0 182 079. It comprises a soluble polyimide resin, a solvent for the polyimide resin, an epoxy resin, a hardener, a catalyst to accelerate the curing of the epoxy resin, a crosslinking agent reactive with the polyimide solvent, and a catalyst to catalyze the crosslinking reaction. The adhesives which can be used in accordance with the present invention can be broadly selected from electrically conductive and/or thermally conductive adhesives which are useful for component bonding, e.g., die bonding. The adhesive 12 is preferably partially reacted to a tacky state to affix the component to its surface.

As shown in Fig. 1, a pick-and-place apparatus 15, such as conventionally used in the industry, has affixed thereto a semiconductor component 16, e.g., in this case, a semiconductor die. The apparatus 15 and component 16 are then brought into contact with the adhesive 12 carried by support film 13. The result of this operation is shown in Fig. 2 of the drawings.

After a sufficient amount of time has been allowed to elapse, the adhesive 12 "wets out" or bonds to the surface of the semiconductor component 16 so that the component/adhesive composite is adapted to be bonded, in a later operation, to the dielectric support (not shown). Generally this wet-out time can, for example, be anywhere from about 10 to about 60 minutes. The time will vary in regard to the type of adhesive used. It is well within the ability of the person skilled in the art to determine the appropriate time.

The removal of apparatus 15, component 16 and its adherent layer of adhesive 12a is shown in Fig. 3. After sufficient bonding strength has been developed between the component 16 and the adhesive 12 due to the "wet-out" phase, the removal of the component 16 by the apparatus 15 will extract from the adhesive 12 a continuous layer 12a that is of sufficient area and size to allow for the later bonding of the semiconductor 16 to the dielectric support. The use of the word "continuous" herein in describing layer 12a is meant to distinguish over a non-continuous ring-line (or gasket-like) shape such as described in IBM Technical Disclosure Bulletin, Vol.18, No 6, p. 1796 (Nov. 1975) for the sealing of module covers.

The foregoing should not be construed in a limiting sense since it is supplied for illustration only. The scope of protection that is desired is set forth in the claims which follow:

## Claims

1. A process for forming an adherent layer of component bonding adhesive (12a) to a semiconductor component (16) to allow for subsequent bonding of the component fo a dielectric support which comprises:

    a) bonding a semiconductor component to a pattern of curable component bonding adhesive (12) detachably supported on a support film (13), the area of the pattern of component bonding adhesive being substantially larger than the area of the component (16); and

    b) thereafter removing the semiconductor component (16) with continuous adherent layer of component bonding adhesive (12a) from the support film (13), such that the portion (12a) of the adhesive pattern in Bonding contact with the component (16) readily tears away from the remaining adhesive (12), the area of the adherent layer of the component bonding adhesive (12a) being of a size to allow for later bonding of the area of the semiconductor component to said dielectric support.

2. A process as claimed in Claim 1 wherein the support film has a release layer on which the adhesive pattern rests.

3. A process as claimed in Claim 1 wherein the adhesive is a polyimide-modified epoxy resin.

4. A process as claimed in Claim 2 wherein the adhesive is a polyimide-modified epoxy resin.

5. A process as claimed in Claim 1 wherein the component is a die.

6. A process as claimed in Claim 2 wherein the component is a die.

7. A process as claimed in Claim 3 wherein the component is a die.

## Patentansprüche

1. Verfahren zum Herstellen einer Klebeschicht eines ein Element befestigenden Klebstoffes (12a) an einem Halbleiterelement (16), um das anschließende Befestigen des Elementes an einem dielektrischen Träger zu ermöglichen, das umfaßt:

    a) Befestigen eines Halbleiterelementes an einem Muster eines das Element befestigenden, härtbaren Klebstoffes (12), das sich ablösbar auf einem Trägerfilm (13) befindet, wobei die Fläche des das Element befestigenden Musters des Klebstoffes wesentlich größer als die Fläche des Elementes (16) ist, und

    b) anschließendes Entfernen des Halbleiterelementes (16) mit der kontinuierlichen Klebeschicht des das Element befestignden Klebstoffes (12a) vom Trägerfilm (13) in einer Weise, daß der Teil (12a) des Klebstoffmusters, der sich in Klebekontakt mit dem Element (16) befindet, leicht vom verbleibenden Klebstoff (12) abreißt, wobei die Fläche der Klebeschicht des das Element befestigenden Klebstoffes (12a) eine solche Größe hat, daß ein späteres Befestigen der Fläche des Halbleiterelementes an dem dielektrischen Träger möglich ist.

2. Verfahren nach Anspruch 1, worin der Trägerfilm eine Trennschicht aufweist, auf welcher das Klebstoffmuster aufliegt.

3. Verfahren nach Anspruch 1, worin der Klebstoff ein polyimidmodifiziertes Epoxyharz ist.

4. Verfahren nach Anspruch 2, worin der Klebstoff ein polyimidmodifiziertes Epoxyharz ist.

5. Verfahren nach Anspruch 1, worin das Element ein Chip ist.

6. Verfahren nach Anspruch 2, worin das Element ein Chip ist.

7. Verfahren nach Anspruch 3, worin das Element ein Chip ist.

## Revendications

1. Un procédé pour former une couche adhérante d'un adhésif (12a) de fixation des composants sur un composant semi-conducteur (16) pour permettre la fixation ultérieure du composant sur un support diélectrique qui comprend:

a) la fixation d'un composant semi-conducteur sur une configuration d'adhésif (12) vulcanisable de fixation des composants supporté de manière amovible sur un film support (13), la surface de la configuration de l'adhésif de fixation des composants étant sensiblement supérieure à la surface du composant (16); et

b) le dégagement ultérieur du composant semi-conducteur (16) avec la couche continue adhérante de l'adhésif de fixation des composants (12a) par rapport au film support (13) de façon que la partie (12a) de la configuration d'adhésif en contact de fixation avec le composant (16) se déchire facilement de l'adhésif restant (12), la surface de la couche adhérante de l'adhésif (12a) de fixation des composants étant d'une dimension qui permet la fixation ultérieure de la surface du composant semi-conduxteur audit support diélectrique.

2. Un procédé comme revendiqué à la revendication 1, dans lequel le film support comporte une couche de dégagement sur lequelle repose la configuration adhésive.

3. Un procédé comme revendiqué à la revendication 1, dans lequel l'adhésif est une résine éxpoxyde modifiée à la polyimide.

4. Un procédé comme revendiqué à la revendication 2, dans lequel l'adhésif est une résine époxyde modifiée à la polyimide.

5. Un procédé comme revendiqué à la revendication 1, dans lequel le composant est une puce.

6. Un procédé comme revendiqué à la revendication 2, dans lequel le composant est une puce.

7. Un procédé comme revendiqué à la revendication 3, dans lequel le composant est une puce.

FIG.1

FIG.2

FIG.3